# EUROPEAN PATENT APPLICATION

(11) **EP 2 792 721 A1**
(43) Date of publication of application: **22.10.2014**
(21) Application number: 12857139.5
(22) Date of filing: 10.12.2012
(51) Int. Cl.: C09J 4/02, C09J 5/06, C09J 163/10, H05K 1/14, H01R 11/01, H01R 43/00

(54) **ADHESIVE AGENT, AND METHOD FOR CONNECTING ELECTRONIC COMPONENT**

(30) Priority: 15.12.2011 JP 2011274840
(71) Applicant: Dexerials Corporation, Tokyo 141-0032 (JP)
(72) Inventor: ODAKA, Ryosuke, Tokyo 141-0032 (JP); SATO, Daisuke, Tokyo 141-0032 (JP)
(74) Representative: Müller - Hoffmann & Partner
(86) International application number: PCT/JP2012/081932
(87) International publication number: WO 2013/089062

(57) **Abstract**

Provided are an adhesive agent capable of providing sufficient electrical continuity to a substrate to which a preflux treatment has been applied and a method for connecting electronic components. There is used an adhesive agent comprising a (meth)acrylate having an epoxy group in one molecule and a radical polymerization initiator having a one minute half-life temperature of 110 degrees C or more. A surplus adhesive agent component between terminals flows, whereby an imidazole component in a preflux, the component binding to an epoxy group of an epoxy group-containing acrylate, is drawn out thereby to be removed from a surface of the terminal.

## Description

### Field of the Invention

The present invention relates to an adhesive agent and a method for connecting electronic components by the use of said adhesive agent. The present application asserts priority rights based on JP Patent Application 2011-274840 filed in Japan on December 15, 2011. The total contents of disclosure of the Patent Application of the senior filing date are to be incorporated by reference into the present Application.

### Background of the Invention

In recent years, a preflux treatment by using a resin type preflux has been applied to a substrate in order to protect a circuit portion of the substrate. However, a connection method by using an electrically conductive adhesive agent to perform compression-bonding at relatively low temperature causes a problem that a preflux layer present on a terminal prevents electrical continuity.

In order to solve this problem, there has been proposed a method in which an organic film decomposition component, such as an acid component, is blended into an anisotropic conductive adhesive film (for example, refer to Patent Literature 1), a method in which a preflux is washed and removed with trichloroethane or the like before compression-bonding (for example, refer to Patent Literature 2), and the like.

However, the method according to Patent Literature 1 causes to limit the degree of flexibility in blending and also causes to corrode a member, such as a terminal, by the acid component or the like. Furthermore, the method according to Patent Literature 2 requires more processes to be performed, thereby increasing a production cost.

### Prior-Art Documents

### Patent Document

PTL 1: Japanese Patent Application Laid-Open No. 2011-77045
PTL 2: Japanese Patent Application Laid-Open No. H5-63355

### Summary of the Invention

The present invention is proposed in view of such conventional actual circumstances, and provides an adhesive agent capable of providing sufficient electrical continuity to a substrate to which a preflux treatment has been applied, and a method for connecting electronic components.

The present inventors earnestly studied, and consequently found that the use of a (meth)acrylate having an epoxy group in one molecule and the use of a radical polymerization initiator having a one minute half-life temperature equal to or more than a predetermined temperature can provide sufficient electrical continuity to a substrate to which a preflux treatment has been applied.

In other words, an adhesive agent according to the present invention comprises a (meth)acrylate having an epoxy group in one molecule and a radical polymerization initiator having a one minute half-life temperature of 110 degrees C or more.

Also, a method for connecting electronic components according to the present invention is characterized in that an adhesive agent containing a (meth)acrylate having an epoxy group in one molecule and a radical polymerization initiator having a one minute half-life temperature of 110 degrees C or more is sandwiched between a terminal of a first electronic component and a terminal of a second electronic component, at least any one of the first electronic component and the second electronic component having undergone a preflux treatment; and the first electronic component is thermally compression-bonded to the second electronic component, whereby the terminal of the first electronic component is electrically connected to the terminal of the second electronic component.

### Effects of Invention

According to the present invention, the use of a (meth)acrylate having an epoxy group in one molecule and the use of a radical polymerization initiator having a one minute half-life temperature of 110 degrees C or more allow a preflux to be removed at the time of thermocompression bonding, thereby securing electrical continuity, and then an adhesive component is completely cured, therefore sufficient electrical continuity can be provided to a substrate to which a preflux treatment has been applied.

### Detailed Description of the Invention

Hereinafter, an embodiment of the present invention will be described in detail in the following order.
1. Adhesive agent
2. Method for connecting electronic components
3. Examples

### <1. Electrically conductive adhesive agent>

An adhesive agent according to the present embodiment can be suitably used in the case where a preflux treatment is applied to at least any one of a first electronic component and a second electronic component and a terminal of the first electronic component is connected to a terminal of the second electronic component. Here, the preflux treatment is a treatment that forms a coating made of imidazoles used as a resin type preflux.

Furthermore, the adhesive agent according to the embodiment comprises a (meth)acrylate having an epoxy group in one molecule (Hereinafter, referred to as an epoxy group-containing acrylate. Here, the (meth) acrylate represents an acrylate and/or methacrylate.) and a radical polymerization initiator having a one minute half-life temperature of 110 degrees C or more. Thus, it is presumed that a preflux component is removed as follows.

For example, when a terminal of a substrate is thermally compression-bonded to a terminal of another substrate with an adhesive agent being sandwiched therebetween, an epoxy group of an epoxy group-containing acrylate binds to a imidazole component contained in a preflux and at the same time a (meth)acryloyl group of the epoxy group-containing acrylate causes a radical polymerization reaction, whereby an adhesive agent component starts to have a high molecular weight. Then, the thermo-compression bonding allows a surplus adhesive agent component between the terminals to flow and be removed, whereby the imidazole component binding to the acrylate is drawn out to be removed from a surface of the terminal. After that, the terminals are electrically connected to each other through a contact between the terminals or via electrically conductive particles if the electrically conductive particles are present, and a curing reaction in the radical polymerization is completed, whereby the substrates are firmly joined to each other.

It should be noted that the use of a thermosetting type epoxy adhesive agent as the adhesive agent can provide sufficient electrical continuity, but, in case of making a repair after the compression-bonding, the use of the epoxy adhesive agent requires much time and effort to make the repair, and therefore a thermosetting type acrylic adhesive agent is preferably used.

A specific example of an adhesive agent is a thermosetting type acrylic adhesive agent having a lower curing temperature at the time of connection, being capable of reducing tact time, and comprising a film forming resin, a polymerizable acrylic compound, and a radical polymerization initiator.

As the film forming resin, a thermoplastic elastomer, such as phenoxy resin, epoxy resin, polyester resin, polyurethane resin, polyamide, or EVA, or the like may be used. Among these, a phenoxy resin synthesized from bisphenol A and epichlorohydrin may be preferably used because of its heat-resisting property and adhesive property.

When the used amount of a film forming resin is too small, there is a tendency that a film is not formed. On the other hand, when the used amount of a film forming resin is too large, there is a tendency that a property of resin removal which is necessary for obtaining electric connection is lowered, and therefore the used amount of the film forming resin is preferably 20 to 80% by mass, more preferably 20 to 60% by mass of a resin solid content (a total of the polymerizable acrylic compound and the film forming resin).

An epoxy group-containing acrylate is used as the polymerizable acrylic compound. Examples of the epoxy group-containing acrylate include 4-hydroxybutyl acrylate glycidyl ether, glycidyl methacrylate, novolac partial epoxy acrylate, 3, 4-epoxycyclohexylmethyl acrylate, 3,4-epoxycyclohexylmethyl methacrylate, or the like. Among these, 4-hydroxybutyl acrylate glycidyl ether is preferably used.

Furthermore, the content of the epoxy group-containing acrylate is preferably 5 × 10⁻⁴ mol or more per 1 g of a binder as a resin component. When the content of the epoxy group-containing acrylate is less than 5 × 10⁻⁴ mol per 1 g of a binder, an epoxy group does not bind to a preflux sufficiently, and therefore it becomes difficult to sufficiently remove the preflux.

Furthermore, other acrylate may be used in combination as a polymerizable acrylic compound, and examples of the acrylate to be used include urethane acrylate, polyethylene glycol diacrylate, phosphate acrylate, 2-hydroxy ethyl acrylate, 2-hydroxypropyl acrylate, 4-hydroxybutyl acrylate, isobutyl acrylate, t-butyl acrylate, isooctyl acrylate, or the like.

When the used amount of the polymerizable acrylic compound is too small, there is a tendency that electrical conductivity reliability is lowered. On the other hand, when the used amount of the polymerizable acrylic compound is too large, there is a tendency that bonding strength is lowered and furthermore the film is not formed, and therefore the used amount of the polymerizable acrylic compound is preferably 20 to 70% by mass, more preferably 30 to 60% by mass of a resin solid content (a total of the polymerizable acrylic compound and the film forming resin).

An organic peroxide, an azo compound, or the like, each having a one minute half-life temperature of 110 degrees C or more, is used as the radical polymerization initiator. Examples of the organic peroxide include di-(4-methylbenzoyl) peroxide (having a one minute half-life temperature of 128.2 degrees C), di-(3-methylbenzoyl) peroxide (having a one minute half-life temperature of 131.1 degrees C), dibenzoyl peroxide (having a one minute half-life temperature of 130.0 degrees C), t-hexyl peroxybenzoate (having a one minute half-life temperature of 160.3 degrees C), t-butyl peroxybenzoate (having a one minute half-life temperature of 166.8 degrees C), 1,1,3,3-tetramethylbutyl peroxy-2-ethylhexanoate (having a one minute half-life temperature of 124.3 degrees C), dilauroyl peroxide (having a one minute half-life temperature of 116.4 degrees C), di-(3,5,5-trimethyl hexanoyl) peroxide (having a one minute half-life temperature of 112.6 degrees C), t-butyl peroxypivalate (having a one minute half-life temperature of 110.3 degrees C,) or the like. Examples of the azo compound include 2,2'-azobis-isobutyronitrile (having a one minute half-life temperature of 116.0 degrees C), 2,2'-azobis-2-methylbutyronitrile (having a one minute half-life temperature of 119.0 degrees C), 1,1'-azobis-1-cyclohexanecarbonitrile (having a one minute half-life temperature of 141.0 degrees C), dimethyl-2,2'-azobisisobutyrate (having a one minute half-life temperature of 119.0 degrees C), 1,1'-azobis-(1-acetoxy-1-phenylethane) (having a one minute half-life temperature of 111.0 degrees C,) or the like. These radical polymerization initiators may be used alone, or two or more kinds of these may be mixed and used.

Among these radical polymerization initiators, a radical polymerization initiators having a one minute half-life temperature of 130 degrees C or more is preferably used. A radical polymerization initiators having a one minute half-life temperature of 130 degrees C or more allows radical polymerization and curing reactions to proceed after a reaction of an epoxy group of an epoxy group-containing acrylate and a preflux on a terminal sufficiently proceeds, whereby the preflux can be sufficiently removed. It should be noted that the use of a radical polymerization initiator having a one minute half-life temperature of over 180 degrees C is not preferable because the use thereof causes damages to a member due to high temperature and an increase in tact time.

When the content of the radical polymerization initiator is too small, there is a tendency that the property of reactivity is lost. On the other hand, when the content of the radical polymerization initiators is too large, there is a tendency that the product life of an adhesive agent is lowered , and therefore the content of the radical polymerization initiator is preferably 0.1 to 30 parts by weight, more preferably 0.5 to 20 parts by weight of 100 parts by weight of the resin.

As other additive component constituting the adhesive agent according to the present embodiment, a monomer for dilution, such as various kinds of acrylic monomers, a filler, a softener, a coloring agent, a flame-retarding agent, a thixotropic agent, a coupling agent, or the like may be contained as needed. Furthermore, the addition of electrically conductive particles to an adhesive agent allows the adhesive agent to be made into an electrically conductive adhesive agent.

The adhesive agent having such constitutions comprises an epoxy group-containing acrylate and a radical polymerization initiator having a one minute half-life temperature of 110 degrees C or more, whereby a preflux is removed at the time of thermocompression bonding, thereby securing electrical continuity, and then an adhesive component is completely cured, and therefore sufficient electrical continuity can be provided to a substrate to which a preflux treatment has been applied.

Next, a method for producing the above-mentioned adhesive agent will be explained by using an example of an adhesive film. A method for producing an adhesive film according to the present embodiment comprises an application step of applying, a composite including a film forming resin, an epoxy group-containing acrylate, and a radical polymerization initiator on a release base material, and a drying step of drying the composite on the release base material.

In the application step, a film forming resin, a (meth)acrylate having an epoxy group in one molecule, and a radical polymerization initiator having a one minute half-life temperature of not less than 110 degrees C are blended as mentioned above and adjusted by using an organic solvent, and then the thus-obtained composite is applied on a release base material, using a bar coater, an application apparatus, or the like.

Examples of the organic solvent to be used include toluene, ethyl acetate, a mixed solvent of these and various kinds of organic solvents. The release base material has a lamination structure obtained by, for example, applying a release agent, such as silicone, to PET (Poly Ethylene Terephthalate), OPP (Oriented Polypropylene), PMP (Poly-4-methlpentene-1), PTFE (Polytetrafluoroethylene), or the like, and the release base material maintains a film form of the composite.

In the subsequent drying step, the composite on the release base material is dried by a heat oven, a heat-drying apparatus, or the like. Thus, there can be obtained an adhesive film which is the above-mentioned adhesive agent in the form of a film.

### <2. Method for connecting electronic components>

Next, a method for connecting electronic components by the use of the electrically conductive adhesive agent will be explained. A specific example of the method for connecting electronic components is such that an adhesive agent containing a (meth)acrylate having an epoxy group in one molecule and a radical polymerization initiator having a one minute half-life temperature of 110 degrees C or more is sandwiched between a terminal of a first electronic component and a terminal of a second electronic component, at least any one of the first electronic component and the second electronic component having undergone a preflux treatment; and the first electronic component is thermally compression-bonded to the second electronic component, whereby the terminal of the first electronic component is electrically connected to the terminal of the second electronic component.

In the present embodiment, the first electronic component is thermally compression-bonded to the second electronic component at a temperature of 160 degrees C or more, more preferably at a temperature of 170 degrees C or more. Thus, a reaction of an epoxy group of an epoxy group-containing acrylate and a preflux on a terminal sufficiently proceeds, and the preflux is sufficiently removed from the terminal, whereby electrical continuity can be achieved sufficiently. It should be noted that a compression-bonding temperature of over 200 degrees C is not preferable because such temperature causes damages to a member due to high temperature, an increase in tact time, an increase in energy consumption, and the like.

The adhesive agent according to the present embodiment may be used in various cases, but, in the case where the first electronic component is a liquid crystal panel, a printed wired board (PWB), or the like, on the other hand, the second electronic component is a flexible printed circuit board, a tape carrier package (TCP) substrate, a chip on film (COF) substrate, or the like, electrically conductive particles are made to be blended into the adhesive agent and the thus-obtained adhesive agent is preferably applied as an anisotropic conductive film.

Furthermore, as an electrically conductive adhesive film containing electrically conductive particles, the adhesive agent may be used to connect a terminal of a solar cell to a tab lead in a solar cell module.

### Examples

### <3. Examples>

Hereinafter, the present invention will be specifically described with examples, but the present invention is not limited to these examples. Here, there was produced an acrylic thermosetting type anisotropic conductive film comprising an acrylate having an epoxy group in one molecule (Hereinafter, referred to as an epoxy group-containing acrylate.) and an organic peroxide having a predetermined one minute half-life temperature. Then, by using this anisotropic conductive film, a printed wired board to which a preflux treatment (Hereinafter, referred to as an OSP [Organic Solderability Preservative] treatment) had been applied was connected to a flexible printed circuit board to which an OSP treatment had been applied, and the electrical continuity resistance and repairability of a thus-obtained connection structure were evaluated. Production of a connection structure for evaluation, evaluation of the electrical continuity resistance thereof, and evaluation of the repairability thereof were performed as follows.

### [Production of connection structure]

An OSP treatment was applied to a flexible printed circuit board (FPC, manufactured by Nippon Steel Chemical Co., Ltd., copper wiring: line/space (L/S) = 100µm/100µm, terminal height: 12 µm). Specifically, a FPC was immersed in a water-soluble preflux (trade name: F2LX, manufactured by Shikoku Chemicals Corporation) having a temperature of 40 degrees C for 1 minute, and then dried.

An OSP treatment was applied also to a printed wired board (PWB, FR-4 grade, manufactured by Panasonic Corporation, copper wiring: line/space (L/S) = 100µm/100µm, wiring height: 35µm) in the same manner as in the case of the FPC.

Furthermore, in consideration of front surface mounting, back surface mounting, and repairability at the time of solder connection, the PWB was made to undergo a reflow at a peak top temperature of 260 degrees C three times.

The thus-OSP treated PWB and FPC were thermally compression-bonded to each other under a predetermined condition by using the later-mentioned anisotropic conductive film, whereby a connection structure was produced.

### [Evaluation of electrical continuity resistance]

By using a digital multimeter (product number: 34401A, manufactured by Agilent Technologies, Inc.), the electrical continuity resistance (initial stage) of each of connection structures was measured when a current of 1 mA was passed by a four-terminal method. In the case where connection structures have electrical continuity resistances of 200 mΩ or less, over 200 mΩ and 500 mΩ or less, and over 500 mΩ, the electrical continuity resistances thereof were evaluated as ○, Δ, and ×, respectively.

### [Evaluation of repairability]

In each of the connection structures, a flexible printed circuit board was removed from a printed wired board, and a cotton swab sufficiently impregnated with IPA (isopropyl alcohol) was rubbed back and forth over a connection portion 50 times, as a result, in the case where a remaining anisotropic conductive film was peeled off, the repairability of the connection structure was evaluated as ○, meanwhile, in the case where a remaining anisotropic conductive film was not peeled off, the repairability of the connection structure was evaluated as ×.

### [Example 1]

### (Production of anisotropic conductive film)

A total of 100 parts by mass of a resin composite was prepared by blending 15 parts by mass of an epoxy group-containing acrylate (trade name: 4HBAGE, manufactured by Nippon Kasei Chemical Company Limited), 27 parts by mass of a bifunctional epoxy acrylate (trade name: 3002A, manufactured by KYOEISHA CHEMICAL Co., Ltd.), 27 parts by mass of a bisphenol-A type phenoxy resin (trade name: YP50, manufactured by Tohto Kasei Co., Ltd.), 18 parts by mass of a butadiene acrylonitrile rubber (trade name: XER-91, manufactured by JSR Corporation), 4 parts by mass of a hydroxyl group containing acrylic rubber (trade name: SG-80H, manufactured by Nagase ChemteX Corporation), 6 parts by mass of an organic peroxide (trade name: NYPER BW, manufactured by NOF Corporation, having a one minute half-life temperature of 130 degrees C), and 3 parts by mass of Ni-Au plated acrylic resin particles having an average particle diameter of 10 µm (manufactured by NIPPON CHEMICAL INDUSTRIAL Co., Ltd.). In the case of using this epoxy group-containing acrylate, the epoxy group content is equal to the number of moles of the epoxy group-containing acrylate, and hence, if 1 part by mass is regarded as 1 g, the number of moles of 15 parts by mass of an epoxy group is 15/200.23, that is, 0.0749 mol. Furthermore, the epoxy group content per 1 g of a binder except electrically conductive particles is 0.0749 mol / (100 parts by mass - 3 parts by mass), that is, 7.72 × 10⁻⁴ mol.

After 100 parts by mass of the resin composite was dissolved in and mixed with 100 parts by mass of a toluene, it was applied to PET to which a release treatment had been given by using a bar coater, and dried by using an oven at 60 degrees C for 10 minutes thereby to volatilize a solvent, whereby an anisotropic conductive film having a thickness of 35 µm was produced.

By using the anisotropic conductive film of Example 1, an FPC to which an OSP treatment had been applied and a PWB to which an OSP treatment had been applied were thermally compression-bonded together at 170 degrees C and 2 MPa for 10 seconds. The electrical continuity resistance of the thus-obtained connection structure was evaluated as ○. The repairability of the connection structure was evaluated as ○. Table 1 shows these evaluation results.

### [Example 2]

By using the anisotropic conductive film of Example 1, an FPC to which an OSP treatment had been applied and a PWB to which an OSP treatment had been applied were thermally compression-bonded together at 160 degrees C and 2 MPa for 10 seconds. The electrical continuity resistance of the thus-obtained connection structure was evaluated as Δ. The repairability of the connection structure was evaluated as ○. Table 1 shows these evaluation results.

### [Reference Example 1]

By using the anisotropic conductive film of Example 1, an FPC to which no OSP treatment had been applied and a PWB to which no OSP treatment had been applied were thermally compression-bonded together at 170 degrees C and 2 MPa for 10 seconds. The electrical continuity resistance of the thus-obtained connection structure was evaluated as ○. The repairability of the connection structure was evaluated as ○. Table 1 shows these evaluation results.

### [Example 3]

### (Production of anisotropic conductive film)

An anisotropic conductive film of Example 3 was produced in the same manner as in Example 1, except that 10 parts by mass of the epoxy group-containing acrylate (trade name: 4HBAGE, manufactured by Nippon Kasei Chemical Company Limited) and 32 parts by mass of the epoxy-ester resin (trade name: 3002A, manufactured by KYOEISHA CHEMICAL Co., Ltd.) were used.

In the case of using this epoxy group-containing acrylate, the epoxy group content is equal to the number of moles of the epoxy group-containing acrylate, and hence the epoxy group content per 1 g of a binder except electrically conductive particles is 5.15 × 10⁻⁴ mol.

By using the anisotropic conductive film of Example 3, an FPC to which an OSP treatment had been applied and a PWB to which an OSP treatment had been applied were thermally compression-bonded together at 170 degrees C and 2 MPa for 10 seconds. The electrical continuity resistance of the thus-obtained connection structure was evaluated as Δ. The repairability of the connection structure was evaluated as ○. Table 1 shows these evaluation results.

### [Example 4]

By using the anisotropic conductive film of Example 3, an FPC to which an OSP treatment had been applied and a PWB to which an OSP treatment had been applied were thermally compression-bonded together at 160 degrees C and 2 MPa for 10 seconds. The electrical continuity resistance of the thus-obtained connection structure was evaluated as Δ. The repairability of the connection structure was evaluated as ○. Table 1 shows these evaluation results.

### [Reference Example 2]

By using the anisotropic conductive film of Example 3, an FPC to which no OSP treatment had been applied and a PWB to which no OSP treatment had been applied were thermally compression-bonded together at 170 degrees C and 2 MPa for 10 seconds. The electrical continuity resistance of the thus-obtained connection structure was evaluated as ○. The repairability of the connection structure was evaluated as ○. Table 1 shows these evaluation results.

### [Example 5]

### (Production of anisotropic conductive film)

An anisotropic conductive film of Example 5 was produced in the same manner as in Example 1, except that an organic peroxide having a one minute half-life temperature of 116.4 degrees C (trade name: PEROYL L, manufactured by NOF Corporation,) was used.

In the case of using this epoxy group-containing acrylate, the epoxy group content is equal to the number of moles of the epoxy group-containing acrylate, and hence the epoxy group content per 1 g of a binder except electrically conductive particles is 7.72 × 10⁻⁴ mol.

By using the anisotropic conductive film of Example 5, an FPC to which an OSP treatment had been applied and a PWB to which an OSP treatment had been applied were thermally compression-bonded together at 170 degrees C and 2 MPa for 10 seconds. The electrical continuity resistance of the thus-obtained connection structure was evaluated as Δ. The repairability of the connection structure was evaluated as ○. Table 1 shows these evaluation results.

### [Example 6]

By using the anisotropic conductive film of Example 5, an FPC to which an OSP treatment had been applied and a PWB to which an OSP treatment had been applied were thermally compression-bonded together at 160 degrees C and 2 MPa for 10 seconds. The electrical continuity resistance of the thus-obtained connection structure was evaluated as Δ. The repairability of the connection structure was evaluated as ○. Table 1 shows these evaluation results.

### [Reference Example 3]

By using the anisotropic conductive film of Example 5, an FPC to which no OSP treatment had been applied and a PWB to which no OSP treatment had been applied were thermally compression-bonded together at 170 degrees C and 2 MPa for 10 seconds. The electrical continuity resistance of the thus-obtained connection structure was evaluated asO. The repairability of the connection structure was evaluated as ○. Table 1 shows these evaluation results.

**[Table 1]**

| Material name | Example 1 | Example 2 | Reference Example 1 | Example 3 | Example 4 | Reference Example 2 | Example 5 | Example 6 | Reference Example 3 |
|---|---|---|---|---|---|---|---|---|---|
| EP828 | - | | | - | | | - | | |
| NOVACURE 3941 HP | - | | | - | | | - | | |
| DCP | - | | | - | | | - | | |
| 4HBAGE | 15 | | | 10 | | | 15 | | |
| 300 2A | 27 | | | 32 | | | 27 | | |
| YP50 | 27 | | | 27 | | | 27 | | |
| XER-91 | 18 | | | 18 | | | 18 | | |
| SG-80H | 4 | | | 4 | | | 4 | | |
| NYPER BW (one minute half-life temperature of 130 degrees C) | 6 | | | 6 | | | - | | |
| PEROYL L (one minute half-life temperature of 116.4 degrees C) | - | | | - | | | 6 | | |
| 10-µm diameter Ni-Au plated acrylic resin particles | 3 | | | 3 | | | 3 | | |
| Total | 100 | | | 100 | | | 100 | | |
| OSP treatment | applied | applied | not applied | applied | applied | not applied | applied | applied | not applied |
| Compression-bonding condition (temp. - sec.) | 170°C -10s | 160°C -10s | 170°C -10s | 170°C -10s | 160°C -10s | 170°C -10s | 170°C -10s | 160°C -10s | 170°C -10s |
| Electrical continuity | ○ | Δ | ○ | Δ | Δ | ○ | Δ | Δ | ○ |
| Repairability | ○ | ○ | ○ | ○ | ○ | ○ | ○ | ○ | ○ |

### [Comparative Example 1]

### (Production of anisotropic conductive film)

An anisotropic conductive film of Comparative Example 1 was produced in the same manner as in Example 1, except that a bisphenol A type liquid epoxy resin (trade name: EP828, manufactured by Japan Epoxy Resins Co., Ltd.) was used in place of the epoxy group-containing acrylate.

By using the anisotropic conductive film of Comparative Example 1, an FPC to which an OSP treatment had been applied and a PWB to which an OSP treatment had been applied were thermally compression-bonded together at 170 degrees C and 2 MPa for 10 seconds. The electrical continuity resistance of the thus-obtained connection structure was evaluated as ×. The repairability of the connection structure was evaluated as ○. Table 2 shows these evaluation results.

### [Comparative Example 2]

By using the anisotropic conductive film of Comparative Example 1, an FPC to which an OSP treatment had been applied and a PWB to which an OSP treatment had been applied were thermally compression-bonded together at 160 degrees C and 2 MPa for 10 seconds. The electrical continuity resistance of the thus-obtained connection structure was evaluated as ×. The repairability of the connection structure was evaluated as ○. Table 2 shows these evaluation results.

### [Reference Example 4]

By using the anisotropic conductive film of Comparative Example 1, an FPC to which no OSP treatment had been applied and a PWB to which no OSP treatment had been applied were thermally compression-bonded together at 170 degrees C and 2 MPa for 10 seconds. The electrical continuity resistance of the thus-obtained connection structure was evaluated as ○. The repairability of the connection structure was evaluated as ○. Table 2 shows these evaluation results.

### [Comparative Example 3]

### (Production of anisotropic conductive film)

An anisotropic conductive film of Comparative Example 3 was produced in the same manner as in Example 1, except that a bifunctional acrylate (trade name: DCP, manufactured by Shin Nakamura Chemical Co., Ltd.) was used in place of the epoxy group-containing acrylate, and an organic peroxide having a one minute half-life temperature of 116.4 degrees C (trade name: PEROYL L, manufactured by NOF Corporation) was used.

By using the anisotropic conductive film of Comparative Example 3, an FPC to which an OSP treatment had been applied and a PWB to which an OSP treatment had been applied were thermally compression-bonded together at 170 degrees C and 2 MPa for 10 seconds. The electrical continuity resistance of the thus-obtained connection structure was evaluated as ×. The repairability of the connection structure was evaluated as ○. Table 2 shows these evaluation results.

### [Comparative Example 4]

By using the anisotropic conductive film of Comparative Example 3, an FPC to which an OSP treatment had been applied and a PWB to which an OSP treatment had been applied were thermally compression-bonded together at 160 degrees C and 2 MPa for 10 seconds. The electrical continuity resistance of the thus-obtained connection structure was evaluated as ×. The repairability of the connection structure was evaluated as ○. Table 2 shows these evaluation results.

### [Reference Example 5]

By using the anisotropic conductive film of Comparative Example 3, an FPC to which no OSP treatment had been applied and a PWB to which no OSP treatment had been applied were thermally compression-bonded together at 170 degrees C and 2 MPa for 10 seconds. The electrical continuity resistance of the thus-obtained connection structure was evaluated as ○. The repairability of the connection structure was evaluated as ○. Table 2 shows these evaluation results.

### [Comparative Example 5]

### (Production of anisotropic conductive film)

An thermosetting type epoxy anisotropic conductive film of Comparative Example 5 was produced in the same manner as in Example 1, except that a bisphenol A type liquid epoxy resin (trade name: EP828, manufactured by Japan Epoxy Resins Co., Ltd.) was used in place of the epoxy group-containing acrylate; 40 parts by mass of a latent imidazole curing agent (trade name: NOVACURE 3941HP, manufactured by Asahi Kasei Chemicals Corp.) was used in place of the organic peroxide; and 20 parts by mass of a bisphenol A type phenoxy resin (trade name: YP50, manufactured by Tohto Kasei Co., Ltd.) was used.

By using the anisotropic conductive film of Comparative Example 5, an FPC to which an OSP treatment had been applied and a PWB to which an OSP treatment had been applied were thermally compression-bonded together at 190 degrees C and 2 MPa for 10 seconds. The electrical continuity resistance of the thus-obtained connection structure was evaluated as ×. The repairability of the connection structure was evaluated as ○. Table 2 shows these evaluation results.

### [Reference Example 6]

By using the anisotropic conductive film of Comparative Example 5, an FPC to which no OSP treatment had been applied and a PWB to which no OSP treatment had been applied were thermally compression-bonded together at 190 degrees C and 2 MPa for 10 seconds. The electrical continuity resistance of the thus-obtained connection structure was evaluated as ○. The repairability of the connection structure was evaluated as ×. Table 2 shows these evaluation results.

**[Table 2]**

| Material name | Comparative Example 1 | Comparative Example 2 | Reference Example 4 | Comparative Example 3 | Comparative Example 4 | Reference Example 5 | Comparative Example 5 | Reference Example 6 |
|---|---|---|---|---|---|---|---|---|
| EP828 | 15 | | | - | | | 15 | |
| NOVACURE 3941 HP | - | | | - | | | 40 | |
| DCP | - | | | 15 | | | - | |
| 4HBAGE | - | | | - | | | - | |
| 3002A | 27 | | | 27 | | | - | |
| YP50 | 27 | | | 27 | | | 20 | |
| XER-91 | 18 | | | 18 | | | 18 | |
| SG-80H | 4 | | | 4 | | | 4 | |
| NYPER BW (one minute half-life temperature of 130 degrees C) | 6 | | | - | | | - | |
| PEROYL L (one minute half-life temperature of 116.4 degrees C) | - | | | 6 | | | - | |
| 10-µm diameter Ni-Au plated acrylic resin particles | 3 | | | 3 | | | 3 | |
| Total | 100 | | | 100 | | | 100 | |
| OSP treatment | applied | applied | not applied | applied | applied | not applied | applied | not applied |
| Compression-bonding condition (temp. - sec.) | 170°C -10s | 160°C -10s | 170°C -10s | 170°C -10s | 160°C -10s | 170°C -10s | 190°C -10s | 190°C -10s |
| Electrical continuity | × | × | ○ | × | × | ○ | ○ | ○ |
| Repairability | ○ | ○ | ○ | ○ | ○ | ○ | × | × |

By a comparison of Examples 1 to 6 and Comparative Examples 1 to 4, it was found that the use of an epoxy group-containing acrylate allows imidazole for an OSP treatment to be removed, thereby achieving electrical continuity sufficiently. Furthermore, by a comparison of Examples 1 to 6 and Comparative Example 5, it was found that an adhesive agent including an epoxy group-containing acrylate has more sufficient repairability than a thermosetting type epoxy adhesive agent.

## Claims

1. An adhesive agent, comprising:
a (meth)acrylate having an epoxy group in one molecule; and
a radical polymerization initiator having a one minute half-life temperature of 110 degrees C or more.

2. The adhesive agent according to claim 1, wherein the above-mentioned radical polymerization initiator has a one minute half-life temperature of 130 degrees C or more.

3. The adhesive agent according to claim 1 or 2, wherein a content of the above-mentioned (meth)acrylate having an epoxy group in one molecule is 5 × 10⁻⁴ mol or more per 1 g of a binder.

4. The adhesive agent according to any one of claims 1 to 3, wherein a preflux treatment is applied to at least any one of a first electronic component and a second electronic component, and a terminal of the first electronic component is connected to a terminal of the second electronic component.

5. A method for connecting electronic components, wherein
an adhesive agent including a (meth)acrylate having an epoxy group in one molecule and a radical polymerization initiator having a one minute half-life temperature of 110 degrees C or more is sandwiched between a terminal of a first electronic component and a terminal of a second electronic component, at least any one of the first electronic component and the second electronic component having undergone a preflux treatment; and
the first electronic component is thermally compression-bonded to the second electronic component, whereby the terminal of the first electronic component is electrically connected to the terminal of the second electronic component.

6. The method for connecting electronic components according to claim 5, wherein the above-mentioned radical polymerization initiator has a one minute half-life temperature of 130 degrees C or more.

7. The method for connecting electronic components according to claim 5 or 6, wherein a content of the above-mentioned (meth)acrylate having an epoxy group in one molecule is 5 × 10⁻⁴ mol or more per 1 g of a binder.

8. The method for connecting electronic components according to any one of claims 5 to 7, wherein the above-mentioned first electronic component is thermally compression-bonded to the above-mentioned second electronic component at 160 degrees C or more.
